# EUROPÄISCHE PATENTSCHRIFT

(11) **EP 2 050 132 B1**
(45) Veröffentlichungstag und Bekanntmachung des Hinweises auf die Patenterteilung: **10.03.2021**
(21) Anmeldenummer: 07785060.0
(22) Anmeldetag: 20.07.2007
(51) Int. Cl.: H01L 21/677

(54) **VORRICHTUNG ZUR LAGERUNG VON OBJEKTEN AUS DEM BEREICH DER FERTIGUNG VON ELEKTRONISCHEN BAUTEILEN**
APPARATUS FOR STORAGE OF OBJECTS FROM THE FIELD OF MANUFACTURE OF ELECTRONIC COMPONENTS
DISPOSITIF D'ENTREPOSAGE D'OBJETS DANS LE DOMAINE DE LA PRÉPARATION DE COMPOSANTS ÉLECTRONIQUES

(30) Priorität: 26.07.2006 CH 12382006
(43) Veröffentlichungstag der Anmeldung: 22.04.2009
(73) Patentinhaber: Tec-Sem AG, 8274 Tägerwilen (CH)
(72) Erfinder: JÄGER, Erich, CH-8500 Frauenfeld (CH)
(74) Vertreter: Klein, Friedrich Jürgen
(86) Internationale Anmeldenummer: PCT/CH2007/000361
(87) Internationale Veröffentlichungsnummer: WO 2008/011741

(56) Entgegenhaltungen:
- US-A- 4 867 629
- US-A- 5 407 181
- US-B2- 6 848 876

## Beschreibung

Die Erfindung betrifft eine Lagervorrichtung für Objekte in der Fertigung von Substraten, insbesondere von Substraten für elektronische Bauteile wie beispielsweise LCD-Displays, wobei die Lagervorrichtung mit einem Gehäuse versehen ist, das zumindest einen im wesentlichen abgeschlossenen Raum zur Lagerung der Objekte ausbildet, eine Reinlufteinrichtung aufweist, mit der zumindest innerhalb eines Abschnitts des Gehäuses eine Reinluftatmosphäre erzeugbar ist, mit mindestens einer Eingabe-/Ausgabe-Einrichtung versehen ist, mittels der Objekte in das Innere des Gehäuses ein- oder aus dem Inneren ausführbar sind, mindestens eine Handhabungseinrichtung aufweist, mit der Objekte im Inneren des Gehäuses handhabbar sind, und Objektaufnahmen innerhalb des Gehäuses aufweist, in denen Objekte außerhalb von Transportbehältern zwischenlagerbar sind.

In der industriellen Fertigung von elektronischen Bauteilen, wie beispielsweise LCD-Displays oder von anderen Flachbildschirmen oder Substraten etc., müssen regelmäßig Objekte innerhalb einer Fabrik transportiert und zwischengelagert werden. Hierfür sind zum einen Transportbehälter vorgesehen, in denen die Objekte gegen äußere Einflüsse sicher angeordnet und transportiert werden. Als Transportbehälter werden häufig sogenannte SMIF- und FOUP-Boxes eingesetzt. Zum anderen werden die Objekte, nach bzw. bevor sie in der Fabrik transportiert werden, in einer Lagervorrichtung, wie eingangs beschrieben, zwischengelagert.

Derartige Lagervorrichtungen weisen in der Regel ein Gehäuse auf, das einen oder mehrere voneinander abgetrennte Räume ausbildet. Um die Objekte in diesen zumindest einen Raum zu überführen bzw. zu entnehmen weisen die Lagervorrichtungen eine verschließbare Öffnung auf. Üblicherweise werden die Objekte maschinell oder manuell aus den Transportbehältern entnommen, bevor sie in den Raum überführt werden. Zum Transport innerhalb der Fabrik werden die Objekte dann wieder aus der Lagervorrichtung entnommen und ausserhalb des Raumes in die ebenfalls ausserhalb der Lagervorrichtung zwischenzeitlich gelagerten Transportbehälter eingesetzt. Aus Gründen der Aufrechterhaltung der Reinraumbedingungen wird üblicherweise angestrebt, die Objekte und die Transportbehälter getrennt voneinander aufzubewahren. Zudem sind die Transportbehälter teuer und voluminös. Wenn in einer Fabrik sehr viele Objekte benutzt werden, dann ist auch üblicherweise die entsprechende Anzahl benötigter Transportbehälter sehr hoch.

Es sind allerdings auch andere Lösungen bekannt geworden, bei denen die Substrate zusammen mit ihren Transportbehältern der Lagervorrichtung zugeführt werden und erst innerhalb der Lagervorrichtung aus dem jeweiligen Transportbehältern entnommen werden. Hier ist vorgesehen, nach der Entnahme der Objekte die Transportbehälter in einem ersten Raum und die Objekte in einem zweiten Raum zu lagern. Die beiden Räume sind durch zum Gehäuse gehörende vertikale Trennwände voneinander getrennt. An dieser Lösung kann jedoch nicht zufrieden stellen, dass sie eine relativ grosse Stellfläche benötigt. Ein weiterer Nachteil ist die konzeptbedingte aufwendige Reinluftversorgung für vergleichsweise grosse Räume.

Aus der US 5,407,181 ist für eine Wärmebehandlungsvorrichtung für Wafer eine Lösung bekannt, bei der eine Speicherkammer für Transportbehälter durch eine vertikale Trennwand von einer Transferkammer der Wärmebehandlungsvorrichtung getrennt ist. In der somit seitlich von der Speicherkammer angeordneten Transferkammer werden Wafer in ein sogenanntes Boat eingesetzt, mit dem die Wafer einem über der Transferkammer angeordneten Reaktionsofen zugeführt werden. Auch diese Wärmebehandlungsvorrichtung benötigt eine vergleichsweise große Stellfläche. Zudem ist bei dieser Vorrichtung keine Zwischenspeicherung von Wafern sondern lediglich ein Transfer einer stets gleich großen Anzahl von Wafern aus Transportbehältern in einen Reaktionsofen möglich.

Die Erfindung liegt deshalb die Aufgabe zugrunde, eine Möglichkeit zu schaffen, durch die Objekte aus der Fertigung von elektronischen Bauteilen und ihre Transportbehälter zum Transport der Objekte in einer Weise zwischengelagert werden können, durch die für die Zwischenlagerung nur eine möglichst kleine Stellfläche in der Fabrik benötigt wird.

Diese Aufgabe wird bei einer Lagervorrichtung gemäß dem Oberbegriff durch die Merkmale von Patentanspruch 1 gelöst. Hierbei ist vorgesehen, dass im gleichen Gehäuse der Lagervorrichtung zwei zumindest teilweise übereinander angeordnete Bereiche ausgebildet sind, wobei ein erster Bereich für eine Objekt-Speichereinrichtung und ein zweiter Bereich für eine Transportbehälter-Speichereinrichtung vorgesehen ist. Die vorliegende Erfindung eignet sich für jegliche Objekte bzw. Substrate aus dem Bereich der Fertigung von elektronischen Bauteilen, Komponenten, Geräten und dergleichen, die innerhalb einer Fertigungsfabrik üblicherweise in Transportbehältern transportiert werden. Die Verwendbarkeit der Erfindung ist unabhängig von der Form (rund, oval rechteckig, achteckig etc.) der Objekte bzw. Substrate und deren Werkstoffe. Des Weiteren eignet sich die Erfindung auch für die Lagerung von in Objektträgern angeordneten Objekte. In einem solchen Anwendungsfall werden die Objekte vorzugsweise zusammen mit ihren Objektträgern in die Objekt-Speicher-einrichtung eingeführt und dort zur Lagerung aufgenommen.

Erfindungsgemäss kann somit vorgesehen sein, die Objekte und die zu ihrem Transport vorgesehenen Transportbehälter zwar voneinander getrennt aber dennoch örtlich nahe zueinander innerhalb des gleichen Gehäuses zu lagern. Sowohl die Objekte als auch die Transportbehälter können mittels der Lagervorrichtung somit für eine vorbestimmte oder eine unbestimmte Zeit so lange dem Fertigungsprozess entnommen werden, bis sie in letzterem wieder benötigt werden. Die Objekte können hierzu aus den Transportbehältern entnommen werden. Hierdurch ist es möglich, chemische Verunreinigungen der Substrate zu vermeiden, die beispielsweise durch Ausgasung der Kunststoffe der Transportbehälter entstehen können. Es hat sich gezeigt, dass insbesondere bei einer längeren Lagerung von Substraten in Transportbehältern solche Kontaminationen entstehen können. Durch die zusätzlich gegebene örtliche Nähe der Lagerstellen der Objekte einerseits und der Transportbehälter andererseits können die Objekte trotz ihrer sicheren kontaminationsfreien Lagerung schnell und flexibel dem Fertigungsprozess wieder zugeführt werden.

Zudem ist es mit der Erfindung möglich, nur so viele Transportbehälter zu bevorraten, wie üblicherweise in der Fabrik für gleichzeitig im Umlauf befindliche Substrate benötigt werden. Anders als bisher, muss die Anzahl an Transportbehältern nicht anhand der Anzahl an insgesamt vorhandenen und zu speichernden Substrate bestimmt werden.

Es ist hierbei ausserdem vorgesehen, dass die zur Aufnahme der Objekte vorgesehene Objekt-Speichereinrichtung und die Transportbehälter-Speichereinrichtung, in der Transportbehälter zwischengelagert werden sollen, zumindest im wesentlichen - vorzugsweise vollständig - übereinander angeordnet sind. Hierdurch benötigt die Lagervorrichtung nur eine besonders geringe Stellfläche. Als besonders günstig hat sich hierbei eine Anordnung gezeigt, bei der sich die Objekt-Speichereinrichtung über der Transportbehälter-Speichereinrichtung befindet. Durch eine solche Anordnung ist trotz der räumlichen Nähe von Transportbehältern einerseits und daraus entnommenen Objekten andererseits, mit geringem technischen Aufwand für die Objekt-Speichereinrichtung eine vorteilhafte Reinluftversorgung von oben über eine Deckenwand der Lagervorrichtung möglich.

Die beiden Bereiche sollten sich zwar im gleichen Gehäuse befinden, sind aber vorzugsweise voneinander abgetrennt, wodurch in den Bereichen voneinander getrennte bzw. isolierte Atmosphären erzeugbar sind. Insbesondere im Bereich der Objekt-Speichervorrichtung soll die Erzeugung und Aufrechterhaltung einer Atmosphäre möglich sein, die hohe Reinheitsanforderungen erfüllt. Die Transportbehälter-Speichereinrichtung kann durch eine zumindest näherungsweise und abschnittsweise horizontal verlaufende Trennwand innerhalb des Gehäuses von der Objekt-Speichereinrichtung getrennt sein. Ein gemeinsamer Antrieb für die beiden Speichereinrichtungen kann hierbei durch die Trennwand hindurchgeführt sein.

Mit Vorteil können innerhalb des Raumes der Lagervorrichtung die Objekte und die Transportbehälter mit jeweils einer Handhabungseinrichtung in die jeweiligen Aufnahmen eingesetzt und aus ihnen entnommen werden. Um eine große Anzahl an Objekten und Transportbehältern speichern zu können und trotzdem mit besonders wenigen Handhabungsschritten und mit kurzen Verfahrwegen auszukommen, kann ein drehbares Karussell vorgesehen sein, das mit den Objektaufnahmen und den Aufnahmen für die Transportbehälter versehen ist. Eine solche Anordnung ermöglicht auch mit geringem technischen Aufwand bei Bedarf eine Erhöhung der Anzahl der Objektaufnahmen durch Austausch gegen Aufnahmen für Transportbehälter oder umgekehrt vornehmen zu können. Eine Erweiterung der Kapazität ist auch durch eine Ergänzung von Aufnahmen möglich, beispielsweise durch Aufsetzen von weiteren Objektaufnahmen auf die bis dahin oberste Objektaufnahmereihe des Karussells.

Das Einsetzen und die Entnahme von Objekten und von Transportbehältern in bzw. aus jeweils einer Aufnahme kann mittels innerhalb des Gehäuses angeordneten Handhabungseinrichtungen erfolgen. Hierbei ist in vorteilhafter Weise jeweils eine Handhabungseinrichtung den Transportbehältern und eine Handhabungseinrichtung den Objekten zugeordnet. Zur Ausführung der hierfür erforderlichen Relativbewegungen zwischen Greifern der Handhabungseinrichtungen und der jeweiligen Aufnahme kann in die Aufnahmen mindestens eine Bewegungsachse gelegt sein, beispielsweise eine Drehbewegung um die vertikale Z-Achse. Die Handhabungseinrichtung kann vorzugsweise Verfahrbewegungen zumindest in Richtung der Z- und der Y-Achse ausführen, um den Greifer in der Höhe der jeweiligen Aufnahme zu positionieren und auf diese zu- und weg zu bewegen.

Innerhalb der Lagervorrichtung kann mit Vorteil vorgesehen sein, dass ein Antrieb der Handhabungseinrichtung der Objekt-Speichereinrichtung unterhalb einer Objekthandlingebene dieser Handhabungseinrichtung angeordnet ist. Die Objekthandlingebene kann durch eine Stelle bzw. eine Ebene des Greifers vorgegeben sein, an welcher dieser Greifer das Objekt aufnimmt. Diese Anordnung bietet den Vorteil, dass der gesamte Objekt-Speicherbereich bis knapp unter die Decke des Gehäuses mit dieser Handhabungseinrichtung erreicht werden kann. Da die unterste, anzufahrende Stelle für diese Handhabungseinrichtung auf Höhe einer Objektentnahme aus der jeweiligen Transportbox vorgesehen sein kann, hat die Antriebsmechanik zum Boden hin genügend Freiraum.

Im Gegensatz dazu kann ein Antrieb der Handhabungseinrichtung für die Transportbehälter-Speichereinrichtung stets oberhalb der Handlingebene bzw. -stelle angeordnet sein, die sich durch den Greifer der Transportbehälter-Handhabungseinrichtung ergibt. Dies ermöglicht die Nutzung des Speicherbereichs für die Transportbehälter bis hinab zum Boden des Gehäuses bzw. bis nahe zum Untergrund auf dem die Lagervorrichtung steht. Da es in bevorzugten Ausführungsformen nicht erforderlich ist, dass die Handhabungseinrichtung der Transportbehälter-Speichereinrichtung in Z-Richtung bis zur Gehäusedecke verfahrbar ist, ergibt sich oberhalb der Objekthandlingebene genügend Raum für die Antriebsmechanik. Eine solche bevorzugte erfindungsgemässe Ausgestaltung der Lagervorrichtung ermöglicht die vollständige Ausnutzung der Höhe der Lagervorrichtung mit Speicherplätzen. Die Speicherkapazität der Lagervorrichtung kann hierdurch erheblich gesteigert werden.

In einer zweckmäßigen erfindungsgemäßen Ausgestaltung kann nur ein Antrieb für beide Karussellteile vorgesehen sein. In einer ersten Variante können mit dem Antrieb beide Karussellteile simultan bewegt werden. In einer zweiten Variante sind die beiden Karussellteile unabhängig voneinander und gegebenenfalls auch in unterschiedliche Drehrichtungen bewegbar.

In einer bevorzugten Ausführungsform der Erfindung kann mit Vorteil für den Bereich der Objektaufnahmen und den Bereich der Transportbehälter eine gemeinsame Reinlufteinrichtung vorgesehen sein, deren Reinluft beide Bereiche durchströmt. Diese Reinlufteinrichtung kann insbesondere in der Weise ausgestaltet sein, dass mittels Luftleitmittel ein Reinluftstrom nacheinander beide Bereiche durchströmt. Alternativ hierzu können auch zwei Teilströme der Reinluft erzeugt werden, die jeweils nur einem Bereich zugeordnet sind. Im Zusammenhang mit der Erfindung sollen unter "Reinluft" nicht nur Gase verstanden werden, die zumindest in etwa der Umgebungsluft entsprechen. Unter dem Begriff "Luft" soll im Zusammenhang mit der Erfindung jedes Gas bzw. Gaszusammensetzung verstanden werden, das bzw. die als Gasstrom zur Schaffung und Aufrechterhaltung von Rein- oder Reinstraumbedingungen innerhalb der Lagervorrichtung geeignet ist. Der Begriff Luft soll insbesondere auch reinen Stickstoff oder reine Gase mit einem hohen Stickstoffanteil erfassen.

Durch diese erfindungsgemäß mögliche Ausgestaltung können mit dem gleichen Reinluftstrom sowohl bei den Objekten als auch bei den zwischengelagerten Transportbehältern Reinraumbedingungen erzeugt werden. Hierbei kann von besonderem Vorteil sein, wenn der gleiche Reinluftstrom zuerst durch den Bereich der Objekte und danach durch den Bereich der Transportbehälter geführt wird.

Die in einer Fabrik benötigte Logistik kann stark entlastet werden, wenn in der Lagervorrichtung auch Messgeräte wie Partikelscanner, Schichtdickenmessgerät und/oder sonstige Metrology-Komponenten eingebaut sind, mit denen Objekte vor oder nach der Lagerung vermessen werden können. Sämtliche hierzu erforderlichen Handhabungsschritte finden dann innerhalb des Gehäuses und nicht in einer Vielzahl von Einzelkomponenten innerhalb der Fabrik statt, die jeweils einzeln von einem Fabrikleitrechner angesteuert und miteinander koordiniert werden müssten.

Eine besondere Flexibilität ergibt sich bei weiteren bevorzugten Ausführungsformen der Erfindung, bei denen die Lagervorrichtung als sogenannte Stand-alone Vorrichtung vorgesehen ist, die in ihrem Gehäuse keine Prozeßanlage enthält, mit der die Objekte im Zusammenhang mit ihrer Fertigung be- oder verarbeitet werden. Der Standort einer solchen Stand-alone Vorrichtung innerhalb einer Fabrik kann ohne größeren Aufwand und im wesentlichen nur nach logistischen Gesichtspunkten jederzeit optimiert werden. Selbstverständlich ist jedoch auch möglich, eine erfindungsgemäße Lagervorrichtung entweder an eine Prozeßanlage anzuschließen oder eine Prozeßanlage in die Lagervorrichtung zu integrieren.

Weitere bevorzugte Ausgestaltungen der Erfindung ergeben sich aus den Ansprüchen, der Beschreibung und der Zeichnung.

Die Erfindung wird anhand von in den Figuren rein schematisch dargestellten Ausführungsbeispielen näher erläutert, es zeigen:
- Fig. 1: eine perspektivische Darstellung einer erfindungsgemäßen Lagervorrichtung;
- Fig. 2: eine Darstellung von oben, in die Lagervorrichtung aus Fig. 1;
- Fig. 3: eine Seitenansicht der geöffneten Lagervorrichtung aus Fig. 1;
- Fig. 4: eine perspektivische Teildarstellung der Lagervorrichtung mit einer darin angeordneten Objekt-Handhabungseinrichtung;
- Fig. 5: eine weitere perspektivische Teildarstellung der Lagervorrichtung;
- Fig. 6: eine perspektivische Darstellung eines Speicherelements mit darauf angeordnetem Substratträger;
- Fig. 7: eine geschnittene perspektivische Darstellung eines mit Speicherelementen gemäss Fig. 6 gebildeten Speichermoduls;
- Fig. 8: eine Seitenansicht eines Speichermoduls;
- Fig. 9: eine Seitenansicht eines geöffneten Speichermoduls;
- Fig.10- 16: perspektivische Darstellungen von Handhabungsschritten eines Modulöffners und einer Objekt-Handhabungseinrichtung zur Entnahme eines Substratträger aus einem Speichermodul;
- Fig.17: eine perspektivische Teildarstellung einer alternativen Objekt-Speichereinrichtung;

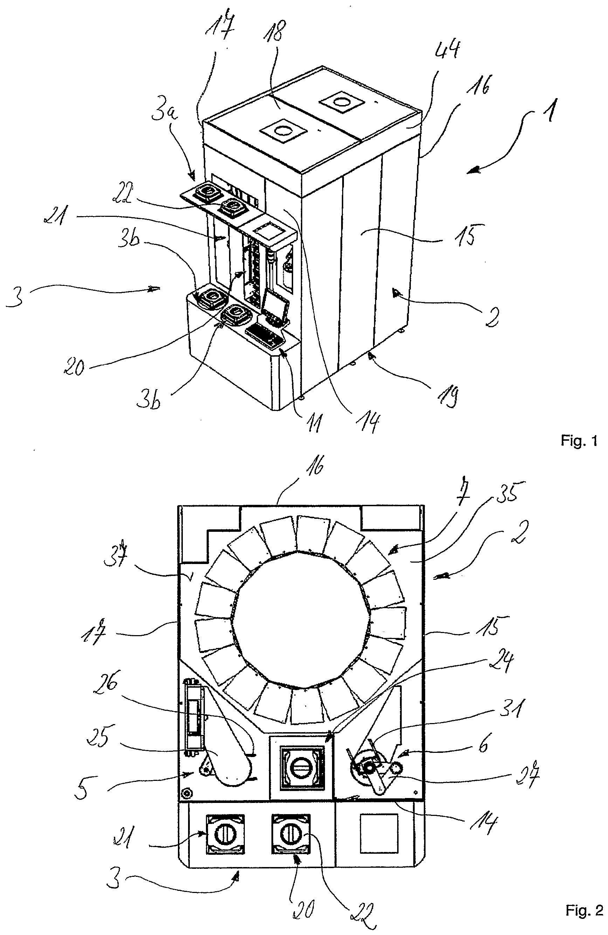

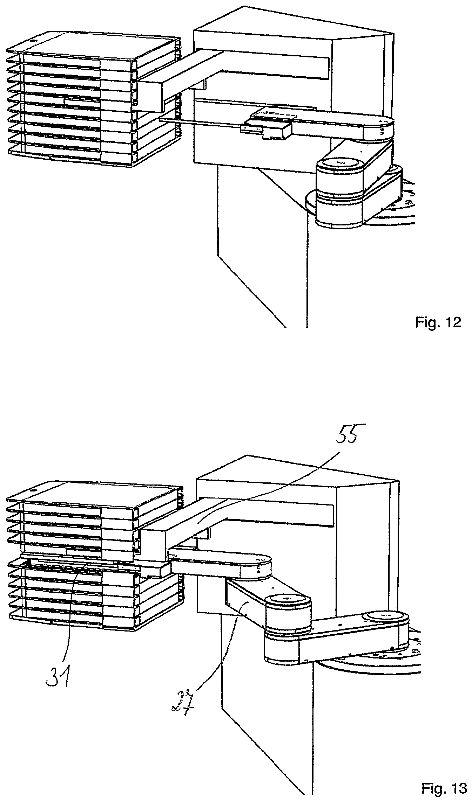

In den Fig. 1 bis 16 ist eine erste Ausführungsform der erfindungsgemässen Lagervorrichtung 1 gezeigt, die zur Speicherung von Objekten aus der Fertigung von elektronischen Bauteilen oder Vorrichtungen, wie beispielsweise Glassubstrate für die Fertigung von LCD-Bildschirmen, und deren Transportbehälter für einen Transport innerhalb einer Produktionsfabrik von elektronischen Bauteilen vorgesehen ist. Solche Objekte können sowohl Werkstücke als auch Produktionsmittel sein, insbesondere Wafer oder Reticles, wobei diese Angaben nur beispielhaft sind und hierdurch die Eignung der erfindungsgemässen Vorrichtung im Zusammenhang mit sämtlichen weiteren Objekten aus dem Bereich der Fertigung elektronischer Bauteile oder Vorrichtungen nicht ausgeschlossen werden soll.

Transportbehälter für solche Objekte, insbesondere Substrate, sind üblicherweise allseitig geschlossen. Die verbreiteste Form von solchen Transportbehältern sind entweder gemäß dem SMIF- oder dem FOUP-Standard (SMIF = Standard Mechanical Interface; FOUP = Front Opening Unified Pod) ausgebildet. SMIF-Transportbehälter weisen eine Haube und einen mit der Haube verschließbaren Boden auf. FOUP-Behälter sind hingegen an einer Frontseite mit einer Öffnung versehen, die mit einem Deckel verschliessbar ist. Die Lagervorrichtung kann prinzipiell zur Aufnahme und Lagerung von Transportbehältern für jeweils nur ein oder für mehrere Lagerungsobjekte, wie beispielsweise Substrate von LCD-Bildschirmen oder andere Substrate ausgebildet werden

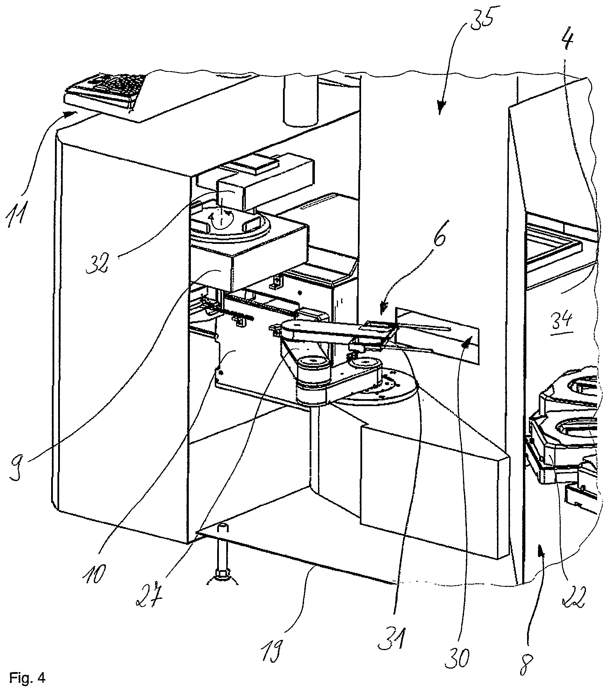

Die Lagervorrichtung weist als Komponenten ein Gehäuse 2, eine Ein-/AusgabeEinrichtung 3, eine Transportbehälter-Öffnungseinrichtung 4 (Fig. 4), eine Transportbehälter-Handhabungseinrichtung 5 (Fig. 2), eine Objekt-Handhabungseinrichtung 6, eine Objekt-Speichereinrichtung 7, eine Transportbehälter-Speichereinrichtung 8, eine ID-Lese-/Ausrichtungseinrichtung 9 sowie optionale Messgeräte wie beispielsweise eine Partikel-Detektionseinrichtung 10 (Fig. 4). Sämtliche Komponenten befinden sich innerhalb des Gehäuses 2.

Das Gehäuse 2 bildet mit seinen beispielsweise aus Blechen bestehenden Seitenwänden 14, 15, 16, 17 sowie Decken- und Bodenwänden 18, 19 einen geschlossenen Raum aus. Das Gehäuse ist hierbei so ausgebildet, dass sowohl die Front- als auch die Rückseite für Wartungszwecke geöffnet werden kann. Die dazwischen liegenden seitlichen Wände 15, 17 des Gehäuses 2 sind hingegen nicht zur Öffnung vorgesehen, weshalb die Lagervorrichtung 1 mit ihren Seitenwänden neben andere Fabrikanlagen oder neben eine Fabrikwand gestellt werden kann. Es kann auf diese Weise insbesondere auf einer geringen Stellfläche eine Reihe von erfindungsgemäss bevorzugten Lagervorrichtungen 1 mit sehr großer Speicherkapazität gebildet werden, bei der die Wartung und ein schneller Notfallzugriff auf sämtliche Komponenten der jeweiligen Lagervorrichtung trotzdem gewährleistet ist.

An einer Forderseite des Gehäuses sind zwei verschließbare Öffnungen 20, 21 einer unteren Ein-/Ausgabe-Einrichtung 3b vorhanden, durch die Gegenstände ein- und ausgeführt werden können. Unmittelbar oberhalb dieser Öffnung sind zwei obere Ein-/Ausgabeeinrichtung 3a angeordnet, die zur automatisierten Einführung von Transportbehältern 22 in das Innere des Gehäuses 2 sowie zur Ausführung aus dem Gehäuse 2 heraus vorgesehen ist. Die beiden oberen Ein-/Ausgabeeinrichtungen 3a sind dazu bestimmt, automatisiert aus der Fabrik zugeführte Transportbehälter 22, beispielsweise durch ein Overhead-Transportsystem, zu übernehmen bzw. an dieses Transportbehälter 22 aus der Lagervorrichtung 1 abzugeben. Unmittelbar unterhalb der beiden Öffnungen sind zwei "manuelle" Ein-/Ausgabeeinrichtungen 3b vorgesehen, auf denen manuell Transportbehälter 22 plaziert werden, damit diese dann durch Absenken des Behälters automatisiert in das Gehäuse 2 eingeführt werden. Mit der Lagervorrichtung 1 können auch aus dem Inneren des Gehäuses 2 Transportbehälter 22 an die "manuelle Ein-/Ausgabeeinrichtung ausgegeben werden. Derartige Ein-/Ausgabeeinrichtungen 3a und 3b sind beispielsweise durch die von der Anmelderin Tec-Sem AG bereits angebotenen Test Wafer Stocker TWS300 oder das Produkt "Practor 300 mit Foup Buffer" vorbekannt.

Von einer der Ein-/Ausgabeeinrichtungen 3a, 3b gelangt ein Transportbehälter 22 zu der sich bereits vollständig innerhalb des Gehäuses 2 angeordneten Transportbehälter-Öffnungseinrichtung 4, die prinzipiell in gleicher Weise ausgebildet sein kann, wie dies in der EP 0 875 921 A1 für SMIF-Transportbehälter beschrieben ist. Prinzipiell ist im Zusammenhang mit der Erfindung jedoch auch jede andere Transportbehälter- Öffnungseinrichtung 4 geeignet, mit der sich die jeweiligen Transportboxen öffnen und verschliessen lassen.

Die Transportbehälter gelangen beispielsweise mittels einer Dreheinrichtung, die sich vorzugsweise unterhalb einer Platte befindet, auf welcher der jeweilige Transportbehälter abgestellt wird und die die Platte durch Drehung um eine Achse in Richtung der Transportbehälter-Handhabungseinrichtung dreht, zur Transportbehälter-Öffnungseinrichtung 4. Die Transportbehälter-Handhabungseinrichtung 5 kann den jeweiligen Transportbehälter in dieser Ausrichtung greifen und in das System bewegen. Die Transportbehälter weisen an ihrer Oberseite einen genormten Handlingadapter auf, mit dem sie von der Transportbehälter-Handhabungseinrichtung 5 gegriffen werden.

Die Transportbehälter-Öffnungseinrichtung 4 dient zum automatisierten Öffnen und Verschliessen von Transportbehältern 22 innerhalb der Lagervorrichtung. Bei der dargestellten Ausführungsform der Erfindung ist somit vorgesehen, dass die Transportbehälter samt ihres Inhalts verschlossen in das Innere der Lagervorrichtung 1 eingeführt und erst dort geöffnet werden.

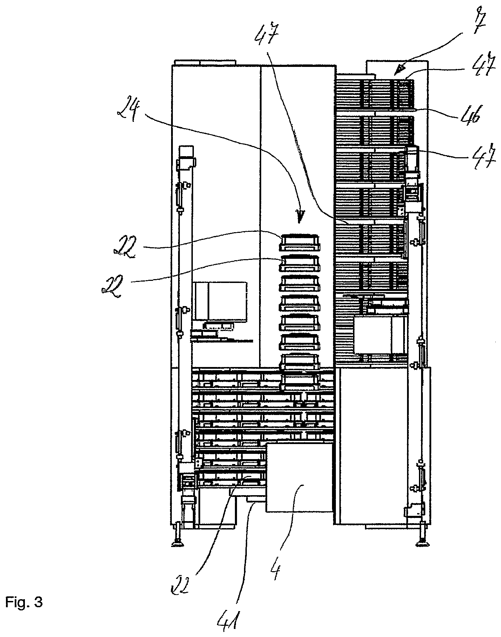

Wie insbesondere in Fig. 3 zu erkennen ist, ist unmittelbar über der Transportbehälter-Öffnungseinrichtung 4 ein Buffer 24 für eine vergleichsweise geringe Anzahl von Transportbehältern 22 vorgesehen. Dieser Buffer 24, in dem beispielsweise zehn, vorzugsweise leere, Transportbehälter 22 aufgenommen werden können, dient dazu, besonders schnell ein oder mehrere Objekte in einen Transportbehälter zu überführen und aus der Lagervorrichtung auszuführen. Durch den Buffer 24 steht praktisch unmittelbar nach Anforderung eines bestimmten Objekts ein Transportbehälter zur Aufnahme des entsprechenden Objekts und zum nachfolgenden Hinausführen aus der Lagervorrichtung bereit. Es kann hierdurch die Transferzeit für die Entnahme eines Transportbehälters 22 aus der nachfolgend noch näher beschriebenen Transportbehälter-Speichereinrichtung 8 hin zur Transportbehälter-Öffnungseinrichtung 4 vermieden werden. Es ist ebenfalls möglich, die Transportbehälter 22 im Buffer 24 bereits mit durch ein Host System angeforderten Objekten, wie Substraten, zu füllen. Beim Abruf zur Ausgabe können diese dann ohne Verzögerung aus dem Stocker bzw. der Lagervorrichtung ausgegeben werden. Ein ähnlicher Vorteil ist auch durch eine Lagerung von mit Substraten gefüllten Transportbehälter im Transportbehälter-Speicherbereich erzielbar.

In einem insbesondere in Fig. 2 zu erkennenden Eckbereich der Frontwand mit einer Seitenwand der Lagervorrichtung befindet sich die Transportbehälter-Handhabungseinrichtung 5, mit der Transportbehälter von der Transportbehälter-Öffnungseinrichtung 4 zur Transportbehälter-Speichereinrichtung und vice versa transportiert werden kann. Die Transportbehälter-Handhabungseinrichtung 5 ist im Ausführungsbeispiel als Knickarmroboter 25 ausgebildet, der entlang einer Z-Achse (senkrecht zur Zeichenebene von Fig. 2) in vertikaler Richtung längsverfahrbar ist. Mit dem Knickarm führt der Knickarmroboter 25 Bewegungen innerhalb von X-Y-Ebenen (parallel zur Zeichen-ebene von Fig. 2) aus. Zur Handhabung der Transportbehälter ist am Knickarm ein passiver Greifer 26 befestigt, mit dem der Knickarmroboter an dem obenseitigen Handlingadapter des jeweiligen, im Ausführungsbeispiel als SMIF-Box ausgebildeten Transportbehälters 22, angreift.

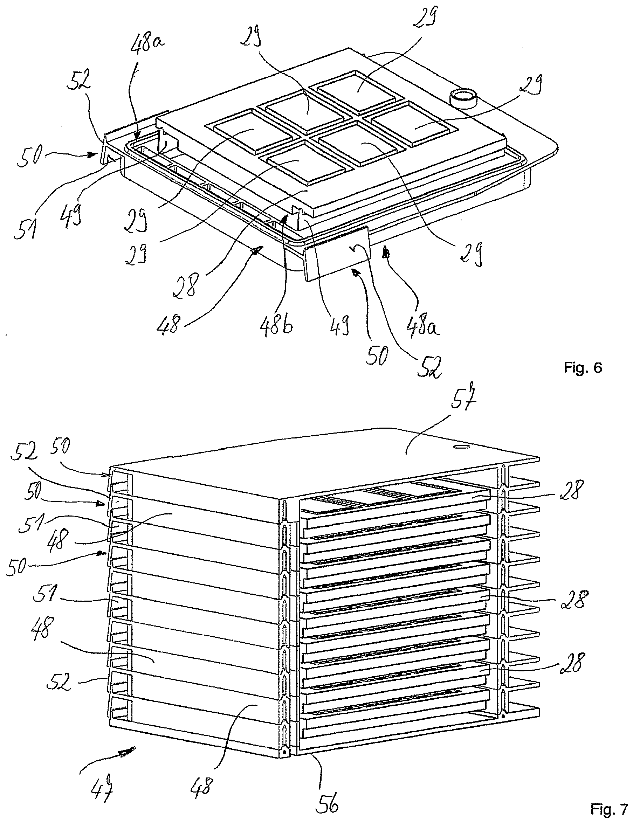

Im gegenüberliegenden Eckbereich der Frontwand befindet sich auf der anderen Seite der Transportbehälter-Öffnungseinrichtung 4 die Objekt-Handhabungseinrichtung 6. Diese ist in prinzipiell gleicher Weise ausgebildet wie die Transportbehälter-Handhabungseinrichtung 5, also auch als in der X-Y-Ebene beweglicher Knickarmroboter 27, der zudem in Z-Richtung verfahrbar ist. Der Knickarmroboter 27 der Objekt-Handhabungseinrichtung ist zum Transport und Handhabung von in Substratträgern 28 angeordneten Substraten 29 (s. beispielsweise Fig. 6) von der Transportbehälter-Öffnungseinrichtung 4 zur Objekt-Speichereinrichtung 7 und vice versa vorgesehen. An diesem Knickarmroboter 27 ist vorzugsweise ein passiver Zweiarm-Greifer 31 für die Handhabung von einzelnen Substratträgern 28 angebracht, der durch eine Öffnung 30 in die Transportbehälter-Öffnungseinrichtung 4 hineingreifen kann, um von dort einen Substratträger aufzunehmen oder einen Substratträger 28 an diese Einrichtung zu übergeben. Anstelle von Knickarmrobotern können im Zusammenhang mit der Erfindung auch andere Typen von Handhabungseinrichtungen vorgesehen sein, beispielsweise Roboter mit linearen Bewegungsachsen.

Zum Erfassen eines Substratträgers 28 wird der gabelförmige Greifer 31 unter einen Substratträger 28, der beispielsweise noch in einem Transportbehälter 22 angeordneten ist, gefahren und durch Anheben des Greifers 31 der Substratträger zusammen mit den darin angeordneten Substraten erfasst und nachfolgend durch Bewegung der drei Roboterachsen transportiert.

In unmittelbarer Nähe zur Transportbehälter-Öffnungseinrichtung 4 und zur Objekt-Handhabungseinrichtung 6 ist im Gehäuse 2, unterhalb einer aussen am Gehäuse 2 angeordneten Bedienstation 11 (Fig. 1, Fig. 4), die ID-Lese-/Ausrichtstation 9 angeordnet. Mit letztgenannter können auf Substraten 29 oder Substratträgern 28 anoder eingebrachte Barcodes automatisiert erfasst und damit die Substrate bzw. Substratträger identifiziert werden. Die ID-Lese-/Ausrichtstation kann hierzu mit einer nicht näher dargestellten Kamera sowie mit einer geeigneten Auswertesoftware zur Auswertung der Kamerasignale versehen sein. Derartige optische Erkennungssysteme zum Auslesen von in Strichcodes enthaltenen Informationen sind an sich vorbekannt. Mit der ID-Lese-/Ausrichtstation 9 können die Objekte durch eine Drehbewegung gegebenenfalls vor die Kamera 32 der Station 9 in eine Position gebracht werden, in der die Kamera 32 den Barcode oder ein sonstiges Identifikationsmittel lesen kann. Wird beim ersten Lesevorgang an einer der jeweiligen Seitenflächen des Objekts kein Barcode erkannt, so kann davon ausgegangen werden, dass sich dieser an einer um 90°, 180° oder 270° gedrehten Position befindet. Mit der Einrichtung 9 können darauf angeordnete Objekte durch Drehbewegungen der Einrichtung 9 um eine vertikale Z-Achse in die genannte Drehposition überführt werden.

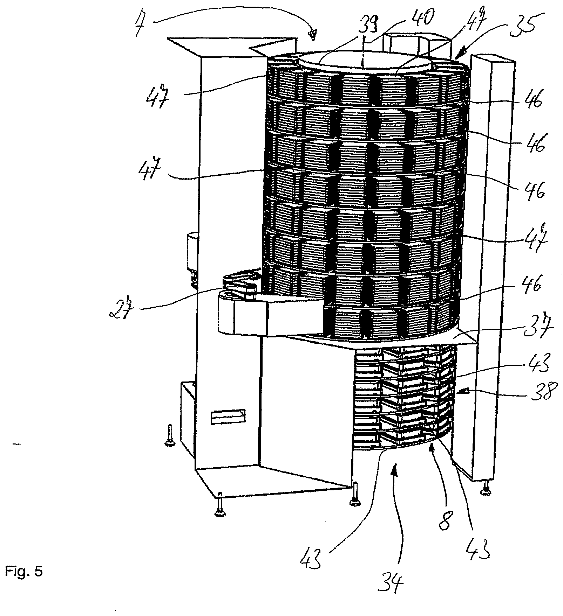

Wie insbesondere in Fig. 5 zu erkennen ist, sind im Gehäuse zwei räumlich voneinander getrennte Bereiche 34, 35 ausgebildet, in denen unterschiedliche Reinraumbedingungen erzeugt werden. Es handelt sich hierbei um einen unteren Bereich 34 für die Transportbehälter-Speichereinrichtung 8 und die Transportbehälter-Handhabungseinrichtung 5 sowie um einen oberen Bereich 35 für die Objekt-Speichereinrichtung 7 und für sämtliche weiteren Komponenten der Lagervorrichtung, die mit den Objekten unmittelbar in Kontakt kommen, wie beispielsweise die ID-Lesestation 32 und die Objekt-Handhabungseinrichtung 6. Im oberen Bereich 35 wird eine Atmosphäre geschaffen, die höchsten Reinraumansprüchen genügt, beispielsweise Reinraumbedingungen wie sie in der Norm 14644-1 "Classification of Air Cleanliness" ISO:1 beschrieben ist. Der untere Bereich 34 erfüllt hingegen nur weniger anspruchsvolle Reinraumbedingungen, was jedoch ausreichend ist, da in diesen Bereich keine Objekte gelangen, erst recht nicht offen gelagerte Objekte, wie dies im oberen Bereich der Fall ist. Die beiden Bereiche sind durch eine horizontale Trennwand 37 voneinander getrennt.

Sowohl die Transportbehälter-Speichereinrichtung 8 als auch die Objekt-Speichereinrichtung 7 sind als zumindest näherungsweise als hohlzylindrische Karussells 38, 39 (Fig. 5) ausgebildet, die um eine gemeinsame vertikale Drehachse 40 drehbar sind. In einer ersten, in Fig. 5 gezeigten, Variante sind die beiden Karussells 38, 39 mit jeweils einem eigenen Antrieb unabhängig voneinander drehbar. Die beiden Speichereinrichtungen 7, 8 können auch gleichzeitig in entgegengesetzte Drehrichtungen um die Drehachse 40 gedreht werden. In einer alternativen Ausführungsform kann auch nur ein gemeinsamer Antrieb für beide Karussells vorgesehen sein, durch den beide Karussells nur gemeinsam drehbar sind. Voneinander unabhängige Bewegungen lassen sich aber auch mit nur einem Antrieb erzeugen, der beispielsweise durch einen Schaltvorgang bzw. eine Kupplung wahlweise auf die eine oder die andere Speichereinrichtung wirkt.

Im gezeigten Ausführungsbeispiel ist nur der elektrische Antrieb 41 des unteren Karussells 38 dargestellt, der im Bodenbereich des Gehäuses 2 angeordnet ist und auf dessen nicht näher dargestellten Abtriebswelle sich eine Riemenscheibe befindet. Ein um die Riemenscheibe geführter Endlosriemen ist des Weiteren auch um ein Scheibe mit deutlich grösserem Durchmesser als die Riemenscheibe geführt, wobei die Drehachse der Scheibe mit der vertikalen Drehachse 40 des Karussells 38 fluchtet. Die Antriebsbewegung des elektrischen Antriebs 41 wird somit untersetzt auf die Transportbehälter-Speichereinrichtung 8 übertragen. Für die Objekt-Speichereinrichtung 7 kann im oberen Bereich 35 eine prinzipiell gleichartige Einrichtung zum Antrieb des mit 39 bezeichnete Karussells vorgesehen sein. Durch eine Drehrichtungsumschaltung des jeweiligen elektrischen Antriebs können beide Speichereinrichtungen in jeweils beide Drehrichtungen gedreht werden.

Die Transportbehälter-Speichereinrichtung 8 weist an ihrer äußeren Umfangsfläche eine Vielzahl von Aufnahmen für Transportbehälter 22 auf, die in Form von mehreren übereinander angeordneten Scheiben 43 horizontal und ringförmig nebeneinander und im Karussell 38 übereinander überangeordnet sind. Durch diese Ausgestaltung ergibt sich eine matrixförmige Anordnung von Aufnahmen für Transportbehälter 22. Im in Fig. 5 gezeigten Ausführungsbeispiel sind beispielsweise durch sechs Scheiben 43 sechs ringförmige Zeilen vorgesehen, in denen jeweils eine Aufnahmekapazität von zwölf Aufnahmen für jeweils einen Transportbehälter 22 vorgesehen ist. Hierdurch ergibt sich eine Aufnahmekapazität von insgesamt 72 Transportbehältern.

Im oberen Bereich 35 wird die Transportbehälter-Speichereinrichtung 8 von einem unter der Deckenwand 18 des Gehäuses 2 angeordneten Reinluftversorgung mit Stickstoff oder Reinluft versorgt (Fig. 1). Hierbei wird von einer Fan-Filter-Einheit 44 ein von oben nach unten etwa mittig in das obere Karussell 39 (Fig. 5) gerichteter Gasstrom erzeugt. Aufgrund der Richtung des Gasstroms und eines Überdrucks im oberen Bereich 35 sowie durch nicht näher dargestellte Durchführungen durch die horizontale Trennwand 37 kann die Reinluft in den unteren Bereich 34 gelangen, nachdem sie den oberen Bereich 35 durchströmt hat. Die Durchführungen können beispielsweise als Perforation der Trennwand 37 ausgebildet sein. Alternativ hierzu kann aber auch für jede Aufnahme eine separate (Rein-)Gasversorgung, insbesondere für Stickstoff, vorgesehen sein. Hieran können die von bestimmten Transportbehälter 22 bereits bekannten Anschlüsse für Gasspülungen der Behälter 22 angeschlossen werden, wodurch auch eine Langzeitlagerung insbesondere unter einer Stickstoffatmosphäre für in den Transportbehältern verbleibende Objekte möglich ist.

Um auf eine bestimmte Aufnahme 42 zuzugreifen ist vorgesehen, dass die betroffene Aufnahme 42 der Transportbehälter-Speichereinrichtung 8 mittels des elektrischen Antriebs 41 in eine vorbestimmte rotatorische Zugriffsposition überführt wird. Ebenso wird die Transportbehälter-Handhabungseinrichtung 5 in Bezug auf die Z-Achse in eine Höhe verfahren, die der Z-Position der jeweiligen Aufnahme 42 entspricht. Hinsichtlich der X-Y-Position wird der Greifer durch eine Verfahrbewegung des Knickarms des Roboters in die Zugriffsposition überführt. Es kann mit Vorteil vorgesehen sein, dass sämtliche Aufnahmen einer Zeile bzw. Scheibe 43 für einen Zugriff in jeweils die gleiche Zugriffsposition überführt werden.

Die über der Transportbehälter-Speichervorrichtung 8 angeordnete Objekt-Speichervorrichtung 7 weist mehrere ringförmige und parallel übereinander angeordnete Regale 46 auf, deren Anzahl veränderbar sein kann. Auf jedem Regal 46 ist die gleiche Anzahl an nachfolgend noch näher erläuterten Speichermodulen 47 angeordnet, wobei jedes Speichermodul 47 mit jeweils zehn aufeinander gestapelten Speicherelementen 48 versehen ist. Wie u.a. in Fig. 6 dargestellt ist, sind die Speicherelemente 48 dieses Ausführungsbeispiels ringförmig in sich geschlossen ausgebildet und näherungsweise viereckförmig. Hierbei ist jedes Speicherelement 48 zur Aufnahme und Ablage von jeweils nur einem Objekt- bzw. Substratträger 28 vorgesehen.

Jedes Speicherelement 48 ist mit einem Lagerbereich 48a und mit einem Speicherbereich 48b versehen. Der Lagerbereich 48a ist hierbei so ausgebildet, dass das jeweilige Speicherelement 48 zur Anordnung, insbesondere zur Stapelung, auf einer Unterlage bzw. auf dem jeweils unter ihm selbst angeordneten Speicherelement 48 geeignet ist. Gleichzeitig ist eine Oberseite des Lagerbereichs 48a dazu vorgesehen, dass auf ihr ein im Stapel nach oben nachfolgendes Speicherelement angeordnet wird. Der Lagerbereich 48b dient zur Aufnahme eines Lagerobjekts. Der prinzipielle Aufbau solcher Speicherelemente 48 und mit Ihnen gebildeten Speichermodule 47 bzw. Speichertürme sowie deren Handhabung ist bereits in der WO 2005/006407 A1 und CH 01150/05 der gleichen Anmelderin beschrieben.

Wie insbesondere in Fig. 6 zu erkennen ist, weist der Speicherbereich 48b jedes Speicherelements auf einer Innenseite an zwei aneinander gegenüberliegenden Seiten zwei zueinander parallel verlaufende Stege 49 auf, auf denen ein Substratträger 28 aufliegt. Die Stege 49 können gegen das Gewicht des Substratträgers zumindest geringfügig elastisch nachgeben. Eine Unterseite eines auf diese Weise von einem Speicherelement aufgenommenen Substratträgers 28 befindet sich zumindest geringfügig über einer unteren Standfläche seines Speicherelements 48, mit dem dieses gegen ein darunter befindliches Speicherelement 48 anliegt. In jedem der übereinander angeordneten Speicherelemente 48 des Speichermoduls ist auf stets gleiche Weise jeweils nur ein Substratträger 28 gelagert. Zudem weist jedes Speicherelement 48 an zwei seiner gegenüberliegenden parallel zueinander verlaufenden Seitenkanten jeweils ein Zentrierelement 50 auf. Jedes der Zentrierelemente 50 ist in Bezug auf eine Blickrichtung von oben nach unten jeweils schräg nach aussen gerichtet. Die Zentrierelemente 50 weisen jeweils eine innere und eine äussere, im wesentlichenen ebene, Zentrierfläche 51, 52 auf.

Zur Stapelung der Speicherelemente 48 zu dem sich in vertikaler Richtung erstreckenden, als Speicherturm ausgebildeten, Speichermodul 47 liegen die beiden inneren Zentrierflächen des jeweils oberen Speicherelements 48 gegen die beiden äußeren Zentrierflächen 52 des jeweils darunter angeordneten Speicherelements 48 an. Bei der Stapelung der stets gleichartigen Speicherelemente findet somit eine durch die beiden konusartig angeordneten Zentrierelemente 50 jedes Speicherelements 48 eine Selbstzentrierung der Speicherelemente im Speichermodul 47 statt.

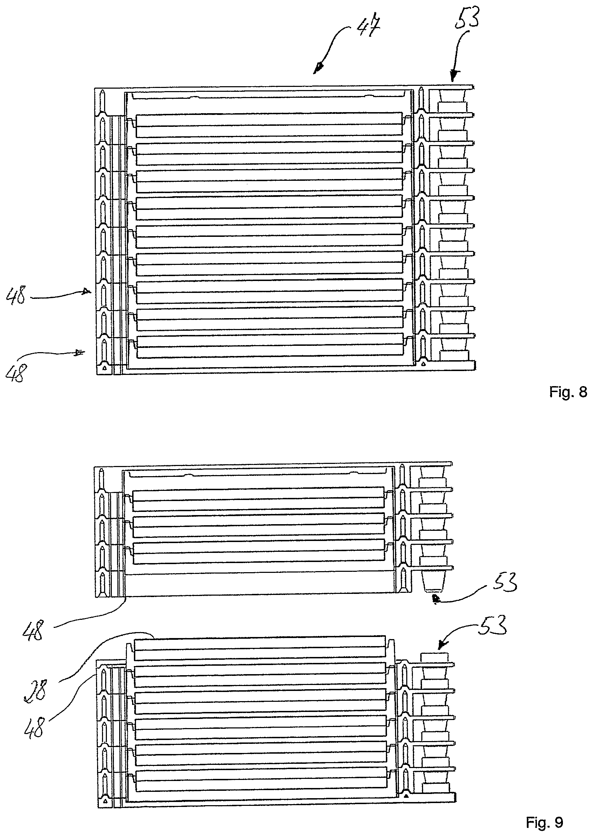

Wie insbesondere in den Fig. 8 und 9 zu erkennen ist, bilden die Speicherelemente 48 jeweils auf einer Seite jedes Speichermoduls 47 einen durchgehenden Kanal 53 aus, durch den Reinraumluft (gefilterte Luft oder Stickstoff) von unten nach oben durch das Speichermodul 47 durchgeleitet werden kann. Eine nicht dargestellte Drehdurchführung für die Reinraumluft erfolgt am unteren oder oberen Ende des Karussells 39 in eine nicht näher dargestellte Druckluftleitung des Karussells der Objekt-Speichereinrichtung 7. Im Inneren wird die Versorgung mit zu den einzelnen Speichermodulen geführten Druckluftleitungen aufgeteilt, an die das jeweils unterste Speicherelement eines Speichermoduls angeschlossen ist. Durch zu den Substraten gerichtete nicht dargestellte Öffnungen des Kanals 53 wird in jedem Speichermodul 47 eine vertikale Partikelbarriere gebildet. Die aufeinander gestapelten Speicherelemente 48 bilden zwischen jeweils zwei aufeinander folgenden Speicherelementen jeweils einen Spalt aus, durch den das im Kanal 53 unter Druck stehende Gas im wesentlichen in horizontaler Richtung über die Substratträger 28 und Substrate 29 strömen kann. Dies kann dazu beitragen, dass während der Lagerung der Substrate eine Spülung der Lagerobjekte mit Reinluft bzw. Stickstoff stattfindet und so eine Kontaminierung mit Partikeln verhindert bzw. bereits vorhandene Kontaminierungen beseitigt werden kann.

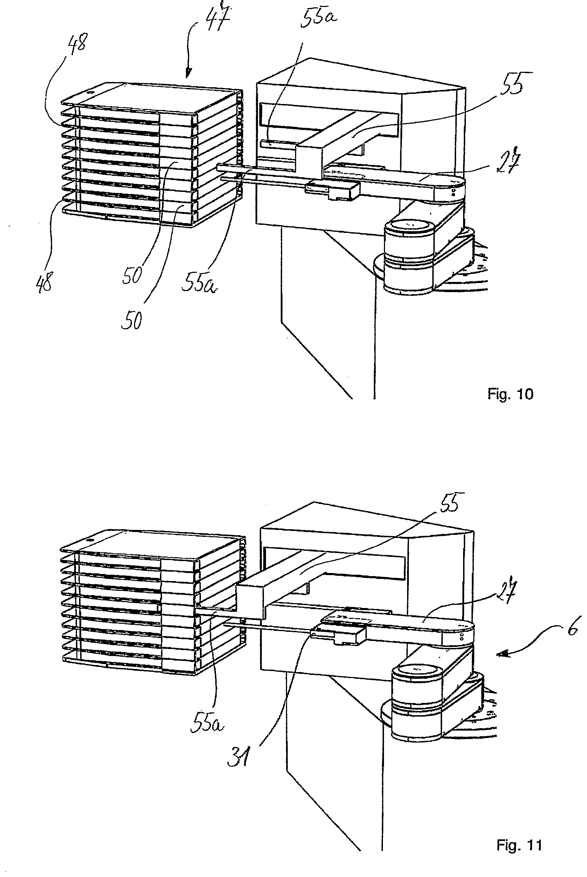

Um auf einen sich in einem Speichermodul 47 befindenden Substratträger 28 zuzugreifen, wird das Speichermodul 47 des jeweiligen Substratträgers 28 mittels des elektrischen Antriebs des Karussells 39 in Bezug auf eine rotative Position des Karussells in eine Zugriffsposition für die Objekt-Handhabungseinrichtung 6 gedreht. Im wesentlichen gleichzeitig kann der Greifer des Knickarmroboters 27 sowie ein ebenfalls gabelförmiger Modulöffner 55 (Fig. 10 bis 16) in Z-Richtung auf die erforderliche Zugriffshöhe für den jeweiligen Substratträger 28 und in Bezug auf die X-Y-Ebene unmittelbar vor das entsprechende Speichermodul 47 überführt werden. Der Modulöffner 55 ist in Z- sowie in X-Richtung jeweils linear verfahrbar. Die Verfahrbarkeit des Modulöffners 55 und der Objekt-Handhabungseinrichtung in Z-Richtung können vorzugsweise durch einen gemeinsamen Antrieb erzeugt werden, was den konstruktiven, insbesondere den mechanischen, Aufwand der Lagervorrichtung reduziert.

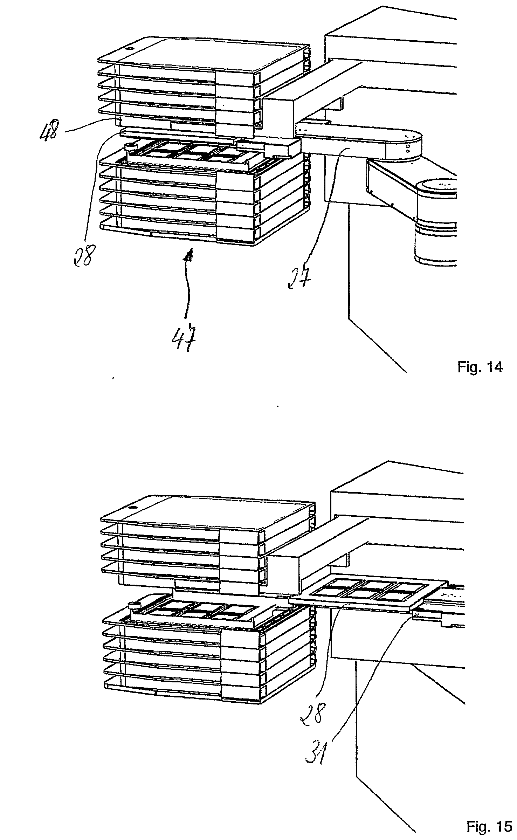

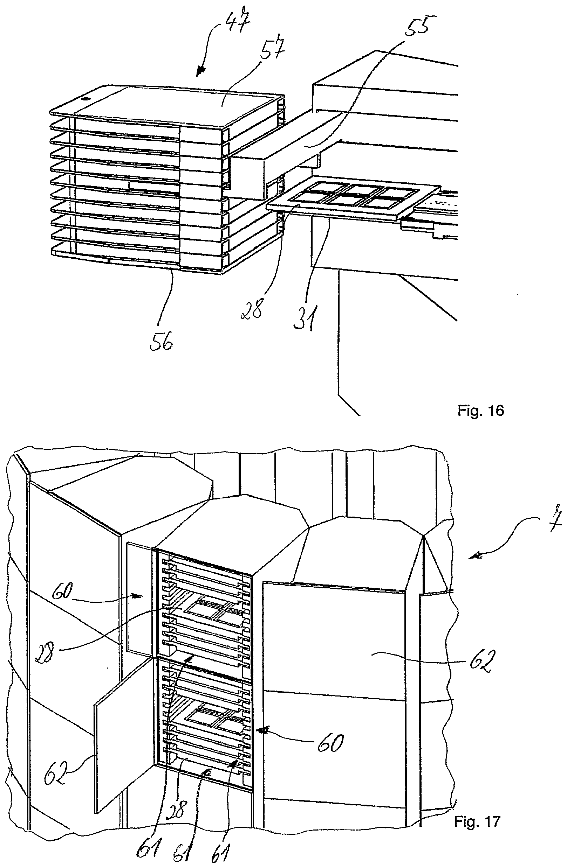

Von hier aus fährt der Modulöffner 55 mit seinen beiden Gabeln jeweils seitlich von den Zentrierelementen 50 in das Speichermodul ein und hebt das Speicherelement an, das sich unmittelbar über dem zu entnehmenden Substratträger 28 befindet (Fig. 10 bis 13). Selbstverständlich werden hierbei auch sämtliche weiteren darüber angeordneten Speicherelemente 48 mit angehoben. Anschliessend nimmt der gabelförmige Greifer 31 den jeweiligen Substratträger 28 zwischen seiner Gabel auf, hebt ihn gegenüber seinem Speicherelement 48 an und entnimmt es aus dem Speichermodul (Fig. 15, 16). Der Modulöffner 55 kann nun wieder abgesenkt und das Speichermodul 47 hierdurch geschlossen werden (Fig. 16). Auf prinzipielle gleiche Weise, jedoch mit entgegengesetzter Bewegungsrichtung des jeweiligen Speicherträgers kann ein solcher auch in ein bestimmtes Speicherelement des Speichermoduls 47 eingeführt werden.

Mit der Objekt-Handhabungseinrichtung 6 kann ein Substratträger auch zur Partikel-Detektionseinrichtung 10 (Fig. 4) überführt, an diese übergeben und nach der Inspektion aus dieser wieder entnommen werden. Eine solche Partikel-Detektionseinrichtung kann beispielsweise gemäß der in der WO 02/01292 A1 beschriebenen Partikel-Detektionseinrichtung ausgestaltet sein. Anstelle einer solchen Detektionseinrichtung kann im Zusammenhang mit der vorliegenden Erfindung prinzipiell auch jede andere Partikel-Detektionseinrichtung eingesetzt werden, die sich in das Gehäuse der Lagervorrichtung integrieren lässt.

Die Lagervorrichtung ist zudem mit einer Steuerungseinrichtung versehen, deren Rechner und Steuerungssoftware die einzelnen Komponenten der Lagervorrichtung miteinander koordiniert, von den Komponenten oder weiteren Sensoren erfasste Daten speichert und gegebenenfalls anderen Komponenten zur Verfügung stellt. Ausserdem kann die Steuerungseinrichtung mit einer übergeordneten Fabriksteuerung verbunden sein. Die Bedienstation 11 der Steuerungseinrichtung ist beispielsweise in Fig. 1 erkennbar.

In bevorzugten Ausführungsformen der Erfindung können die Speichermodule 47 mit Boden- und Deckelelementen 56, 57 (Fig. 7) ausgeführt sein und hierdurch als ganzes gleichzeitig einen unabhängigen Speicher und Transportbehälter bilden, mit dem die Objekte in einer normalen Fabrik-Umgebung transportiert werden können. Dieses System eröffnet insbesondere in einem Notfall die Möglichkeit zur Entnahme von Substraten oder wenn im Inneren des Speicherbereiches Wartungsarbeiten durchgeführt werden müssen. Wenn im Falle einer Maschinenstörung ein Substrat benötigt wird, kann sehr einfach auf dieses zugegriffen werden. Die als Türe ausgebildete Seitenwand der Rückseite wird dazu geöffnet und mit einer manuell bedienbaren Kupplung kann der Antrieb des Karussells 39 gelöst werden. Von Hand kann dann das Karussell 39 an die richtige Stelle gedreht und das Speichermodul 47 mit dem benötigten Substrat nun als ganzes aus der Vorrichtung entnommen werden. Das Speichermodul kann und sollte in geschlossenem Zustand durch die normale Fabrik-Umgebung transportiert und erst an einem Reinraumarbeitsplatz geöffnet werden, um das entsprechende Substrat manuell in einen Transportbehälter umzuladen. Die Substrate befinden sich lückenlos in einer einwandfreien Reinraumumgebung.

In Fig. 17 ist ein weiteres erfindungsgemässes Ausführungsbeispiel gezeigt. Zur Vermeidung von Wiederholungen wird nachfolgend nur auf wesentliche Unterschiede gegenüber dem Ausführungsbeispiel der Fig. 1 bis 16 eingegangen. Hierbei werden prinzipiell identische Komponenten mit gleichen Bezugszeichen benannt.

Das Ausführungsbeispiel von Fig. 17 unterscheidet sich vor allem durch die andersartig gestaltete Objekt-Speichereinrichtung 7 von dem ersten Ausführungsbeispiel. In Fig. 17 ist ausschnittsweise die mögliche Ausführungsform der Objekt-Speichereinrichtung 7 gezeigt, bei der in mehreren Ringen kastenförmige Abteile 60 vorgesehen sind, in denen jeweils mehrere Aufnahmen 61 zur horizontalen Anordnung von Substraten 29 bzw. jeweils einem Substratträgern 28 ausgebildet sind. Jedes Abteil 60 ist mit einer eigenen seitlich schwenkbar angelenkten und abgedichteten Tür 62 verschliessbar. Jedes Abteil 60 wird mittels einem nicht näher dargestellten Stickstoffanschluss permanent gespült. Wenn ein Substratträger 28 entnommen oder eingelegt wird, sinkt der Stickstoffanteil temporär auf das Niveau der Umgebungsluft und steigt wieder an, sobald die Türe geschlossen wird. Zum Öffnen und Schließen der Türen kann eine beispielsweise pneumatisch angetriebene Einrichtung vorgesehen sein, deren Pneumatikzylinder von der Steuerungseinrichtung Betätigungssignale erhält.

**Bezugszeichenliste**

| | | | |
|---|---|---|---|
| 1 | Lagervorrichtung | 26 | Greifer |
| 2 | Gehäuse | 27 | Knickarmroboter (von 6) |
| 3 | Ein-/Ausgabe-Einrichtung | 28 | Substratträger |
| 3a | obere Ein-/Ausgabe-Einrichtung | 29 | Substrat |
| 3b | untere Ein-/Ausgabe-Einrichtung | 31 | Greifer |
| 4 | Transportbehälter-Öffnungseinrichtung | 32 | Kamera |
| | | 33 | Ausrichtungseinrichtung |
| 5 | Transportbehälter-Handhabungseinrichtung | 34 | unterer Bereich |
| | | 35 | oberer Bereich |
| 6 | Objekt-Handhabungseinrichtung | 37 | horizontale Trennwand |
| | | 38 | unteres Karussell |
| 7 | Objekt-Speichereinrichtung | 39 | oberes Karussell |
| 8 | Transportbehälter-Speichereinrichtung | 40 | vertikale Drehachse |
| | | 41 | elektrischer Antrieb |
| 9 | ID-Lese-/Ausrichtungseinrichtung | 42 | Aufnahme |
| | | 43 | Scheibe |
| 10 | Partikel-Detektionseinrichtung | 44 | Fan-Filter-Einheit |
| 11 | Bedienstation | 46 | Regal |
| 14 | Seitenwand | 47 | Speichermodul |
| 15 | Seitenwand | 48 | Speicherelement |
| 16 | Seitenwand | 48a | Lagerbereich |
| 17 | Seitenwand | 48b | Speicherbereich |
| 18 | Deckenwand | 49 | Steg |
| 19 | Bodenwand | 50 | Zentrierelement |
| 20 | Öffnung | 51 | innere Zentrierfläche |
| 21 | Öffnung | 52 | äussere Zentrierfläche |
| 22 | Transportbehälter | 53 | Kanal |
| 24 | Buffer | 55 | Modulöffner |
| 25 | Knickarmroboter (von 5) | 55a | Gabel |
| 56 | Bodenelement | | |
| 57 | Deckelelement | | |
| 60 | Abteil | | |
| 61 | Aufnahme | | |
| 62 | Tür | | |

## Patentansprüche

1. Lagervorrichtung (1) für Objekte in der Fertigung von Substraten, insbesondere von Substraten für elektronische Bauteile, wobei die Lagervorrichtung (1) mit einem Gehäuse (2) versehen ist, das zumindest einen abgeschlossenen Raum zur Lagerung der Objekte ausbildet,
eine Reinlufteinrichtung aufweist, mit der zumindest innerhalb eines Abschnitts des Gehäuses (2) eine Reinluftatmosphäre erzeugbar ist,
mit mindestens einer Eingabe-/Ausgabe-Einrichtung (3, 3a, 3b) versehen ist, mittels der Objekte in das Innere des Gehäuses (2) ein- oder aus dem Inneren ausführbar sind,
mindestens eine Handhabungseinrichtung (6) aufweist, mit der Objekte im Inneren des Gehäuses handhabbar sind, und
eine Objekt-Speichereinrichtung (7) innerhalb des Gehäuses (2) aufweist, in denen Objekte außerhalb von Transportbehältern zwischenlagerbar sind,
im gleichen Gehäuse der Lagervorrichtung (1) zwei zumindest teilweise übereinander angeordnete Bereiche ausgebildet sind, wobei ein erster Bereich für die Objekt-Speichereinrichtung (7) und ein zweiter Bereich für eine Transportbehälter-Speichereinrichtung (8) vorgesehen ist, **dadurch gekennzeichnet, dass** der Bereich für die Objekt-Speichereinrichtung (7) und der zweite Bereich für die Transportbehälter-Speichereinrichtung (6) zumindest im wesentlichen vertikal übereinander angeordnet sind.

2. Lagervorrichtung nach Anspruch 1, **dadurch gekennzeichnet, dass** sich der Bereich der Objekt-Speichereinrichtung (7) über dem Bereich der Transportbehälter-Speichereinrichtung (8) befindet.

3. Lagervorrichtung nach zumindest einem der vorhergehenden Ansprüche, **gekennzeichnet durch** eine karussellartige Anordnung der beiden übereinander angeordneten Speichereinrichtungen (7, 8) für Objekte und für Transportbehälter.

4. Lagervorrichtung nach zumindest einem der vorhergehenden Ansprüche, **gekennzeichnet durch** Mittel zur Erzeugung von Relativbewegungen zwischen den beiden Speichereinrichtungen (7, 8) einerseits und der Handhabungseinrichtung (6) andererseits.

5. Lagervorrichtung nach Anspruch 4, **dadurch gekennzeichnet, dass** die Objekt-Speichereinrichtung (7) und die Transportbehälter-Speichereinrichtung (8) mit Mittel zur Ausführung von Drehbewegungen um eine im wesentlichen vertikale Drehachse (40) versehen sind.

6. Lagervorrichtung nach Anspruch 5, **dadurch gekennzeichnet, dass** die beiden Speichereinrichtungen (7, 8) gemeinsam um die Drehachse (40) drehbar sind.

7. Lagervorrichtung nach zumindest einem der vorhergehenden Ansprüche, **dadurch gekennzeichnet, dass** die beiden Bereiche durch eine Trennwand gegeneinander abgetrennt sind und in beiden Bereichen unterschiedliche Reinraumbedingungen erzeugbar sind.

8. Lagervorrichtung nach zumindest einem der vorhergehenden Ansprüche 1 bis 7, **dadurch gekennzeichnet, dass** für den Bereich der Objekt-Speichereinrichtung (7) und den Bereich der Transportbehälter-Speichereinrichtung (8) eine gemeinsame Reinluftversorgung insbesondere in der Weise vorgesehen ist, dass ein Reinluftstrom nacheinander beide Bereiche durchströmt.

9. Lagervorrichtung nach Anspruch 8, **dadurch gekennzeichnet, dass** zumindest ein Teil des Reinluftstroms zumindest eine Strömungskomponente von aussen in Richtung auf das Innere der karussellartig ausgebildeten Objekt-Speichereinrichtung (7) aufweist.

10. Lagervorrichtung nach zumindest einem der vorhergehenden Ansprüche, **dadurch gekennzeichnet, dass** in dem Gehäuse (2) eine Transportbehälter-Öffnungseinrichtung vorgesehen ist, und vorzugsweise auf deren eine Seite eine Transportbehälter-Handhabungseinrichtung (5) und auf deren anderen Seite eine Objekt-Handhabungseinrichtung (6) zur Handhabung der zu speichernden Objekte angeordnet ist.

11. Lagervorrichtung nach zumindest einem der vorhergehenden Ansprüche, **gekennzeichnet durch** eine Objekt-Handhabungseinrichtung (6) und eine Transportbehälter-Handhabungseinrichtung (5), die jeweils mit einem Antrieb zur Ausführung von Bewegungen in zumindest im wesentlichen vertikaler Richtung versehen sind, wobei der Antrieb der Objekt-Handhabungseinrichtung (6) stets unterhalb eines Greifers der Objekt-Handhabungseinrichtung (6) und der Antrieb der Transportbehälter-Handhabungseinrichtung (5) stets oberhalb eines Greifers der Transportbehälter-Handhabungseinrichtung (5) angeordnet ist.

12. Lagervorrichtung nach zumindest einem der vorhergehenden Ansprüche, **dadurch gekennzeichnet, dass** die Objekt-Speichereinrichtung (7) mehrere Speichermodule (47) aufweist, die jeweils mit mehreren Speicherelementen versehen sind, wobei die zur Aufnahme von jeweils einem Objekt, insbesondere einem Substratträger (28) oder einem Substrat, vorgesehenen Speicherelemente (48) aufeinander stapel- und relativ zueinander bewegbar, insbesondere voneinander separierbar sind.

13. Lagervorrichtung nach Anspruch 12, **dadurch gekennzeichnet, dass** Speichermodule (47) mit Stickstoff flutbar sind, insbesondere durch Zuführung von Stickstoff in einem seitlichen vertikalen Kanal der Speichermodule (47), von dem aus der Stickstoff zumindest näherungsweise horizontal durch die einzelnen Speicherelemente (48) strömt.

14. Lagervorrichtung nach einem der Ansprüche 1 bis 13, mit einer Objekt-Speichermodul zur Anordnung in der Lagervorrichtung, **dadurch gekennzeichnet, dass** das Speichermodul (47) mit mehreren in vertikaler Richtung aufeinander gestapelten und relativ zueinander beweglichen, insbesondere voneinander separierbaren, Speicherelementen (48) versehen ist, jedes Speicherelement (48) einen Aufnahmebereich zur Aufnahme von nur einem Objekt sowie einen Lagerbereich zur Anordnung gegen ein in Stapelrichtung nachfolgendes Speicherelement (48) aufweist.

15. Lagervorrichtung nach Anspruch 14, **dadurch gekennzeichnet, dass** insbesondere aufgrund von einem an der Unterseite des Speichermoduls (47) angeordnetem Boden- (56) und einem an der Oberseite angeordneten Deckelelement (57) im Inneren des Speichermoduls (47) ein gegenüber der Umgebung abgeschlossener Raum ausgebildet ist.

## Claims

1. A storage device (1) for objects in the manufacture of substrates, in particular of substrates for electronic components, wherein the storage device (1) is provided with a housing (2), which comprises at least one enclosed space for storing the objects,
has a clean-air device, with which a clean-air atmosphere can be generated at least within a section of the housing (2),
is provided with at least one input/output device (3, 3a, 3b), by means of which objects can be introduced into the interior of the housing (2) or removed from the interior,
has at least one handling unit (6), with which objects inside of the housing can be handled, and
has an object storage unit (7) inside of the housing (2), in which objects can be temporarily stored outside of transport containers,
two areas arranged at least partially one above the other are formed in the same housing of the storage device (1), wherein a first area is provided for the object storage unit (7) and a second area for a transport container storage unit (8), **characterized in that** the area for the object storage unit (7) and the second area for the transport container storage unit (6) are at least essentially arranged vertically one above the another.

2. The storage device according to claim 1, **characterized in that** the area of the object storage unit (7) is located above the area of the transport container storage unit (8).

3. The storage device according to at least one of the preceding claims, **characterized by** a carousel-like arrangement of the two storage units (7, 8) for objects and transport containers arranged one above the other.

4. The storage device according to at least one of the preceding claims, **characterized by** means for generating relative movements between the two storage units (7, 8) on the one hand and the handling unit (6) on the other.

5. The storage device according to claim 4, **characterized in that** the object storage unit (7) and the transport container storage unit (8) are provided with means for executing rotational movements around an essentially vertical rotational axis (40).

6. The storage device according to claim 5, **characterized in that** the two storage units (7, 8) can together be rotated around the rotational axis (40).

7. The storage device according to at least one of the preceding claims, **characterized in that** the two areas are separated from each other by a partition wall, and varying clean-room conditions can be generated in both areas.

8. The storage device according to at least one of the preceding claims 1 to 7, **characterized in that** a shared clean-air supply of the area of the object storage unit (7) and the area of the transport container storage unit (8) is provided, in particular in such a way that a clean air flow streams consecutively through both areas.

9. The storage device according to claim 8, **characterized in that** at least one part of the clean air flow has at least one flow component from outside in the direction toward the interior of the object storage unit (7) designed like a carousel.

10. The storage device according to at least one of the preceding claims, **characterized in that** a transport container opening unit is provided in the housing, and preferably that a transport container handling unit (5) is provided on its one side, and an object handling unit (6) for handling the objects to be stored is arranged on its other side.

11. The storage device according to at least one of the preceding claims, **characterized by** an object handling unit (6) and a transport container handling unit (5), which each are provided with a drive for executing movements in at least essentially a vertical direction, wherein the drive of the object handling unit (6) is always arranged below a gripper of the object handling unit (6), and the drive of the transport container handling unit (5) is always arranged above a gripper of the transport container handling unit (5).

12. The storage device according to at least one of the preceding claims, **characterized in that** the object storage unit (7) has several storage modules (47), which each are provided with several storage elements, wherein the storage elements (48) provided for receiving a respective object, in particular a substrate carrier (28) or a substrate, can be stacked and moved relative to each other, in particular separated from each other.

13. The storage device according to claim 12, **characterized in that** storage modules (47) can be flooded with nitrogen, in particular by supplying nitrogen in a lateral vertical channel of the storage modules (47), from which the nitrogen flows at least approximately horizontally through the individual storage elements (48) .

14. The storage device according to one of claims 1 to 13, with an object storage module to be arranged in the storage device, **characterized in that** the storage module (47) is provided with several storage elements (48) that are stacked one on top of the other in a vertical direction and can move relative to each other, in particular be separated from each other, and that each storage element (48) has a receiving area for receiving only one object, as well as a storage area to be arranged against a storage element (48) that follows in the stacking direction.

15. The storage device according to claim 14, **characterized in that** an enclosed space relative to the environment is formed inside of the storage module (47), in particular based on a floor element (56) arranged on the lower side of the storage module (47) and a cover element (57) arranged on the upper side.

## Revendications

1. Dispositif de stockage (1) d'objets dans le domaine de la fabrication de substrats, notamment de substrats destinés à des composants électroniques, le dispositif de stockage (1) étant muni d'un boîtier (2), qui forme au moins un espace clos pour le stockage des objets,
comportant un système d'air pur à l'aide duquel au moins à l'intérieur d'un segment du boîtier (2) peut être générée une atmosphère d'air pur,
étant muni d'au moins un système d'entrée/de sortie (3, 3a, 3b), au moyen duquel les objets peuvent être amenés à l'intérieur ou vers l'extérieur du boîtier (2),
comportant au moins un système de manipulation (6), à l'aide duquel les objets sont manipulables à l'intérieur du boîtier, et
comportant un système de stockage des objets (7) à l'intérieur du boîtier (2), dans lequel des objets peuvent être entreposés hors de contenants de transport,
dans le même boîtier du dispositif de stockage (1) étant conçues deux zones au moins partiellement superposées, une première zone étant prévue pour le système de stockage des objets (7) et une deuxième zone étant prévue pour un système de stockage de contenants de transport (8), **caractérisé en ce que** la zone pour le système de stockage des objets (7) et la deuxième zone pour le système de stockage de contenants de transport (6) sont placées au moins en étant sensiblement superposées à la verticale.

2. Dispositif de stockage selon la revendication 1, **caractérisé en ce que** la zone du système de stockage des objets (7) se trouve au-dessus de la zone du système de stockage de contenants de transport (8).

3. Dispositif de stockage selon au moins l'une quelconque des revendications précédentes, **caractérisé par** une configuration en carrousel des deux systèmes de stockage (7, 8) superposés pour des objets et pour des contenants de transport.

4. Dispositif de stockage selon au moins l'une quelconque des revendications précédentes, **caractérisé par** des moyens destinés à générer des déplacements relatifs entre les deux systèmes de stockage (7, 8) d'une part et le système de manipulation (6) d'autre part.

5. Dispositif de stockage selon la revendication 4, **caractérisé en ce que** le système de stockage des objets (7) et le système de stockage de contenants de transport (8) sont munis de moyens destinés à réaliser des déplacements en rotation autour d'un axe de rotation (40) sensiblement vertical.

6. Dispositif de stockage selon la revendication 5, **caractérisé en ce que** les deux systèmes de stockage (7, 8) sont rotatifs en commun autour de l'axe de rotation (40).

7. Dispositif de stockage selon au moins l'une quelconque des revendications précédentes, **caractérisé en ce que** les deux zones sont séparées l'une de l'autre par une cloison de séparation et **en ce que** dans les deux zones peuvent être générées différentes conditions de salle blanche.

8. Dispositif de stockage selon au moins l'une quelconque des revendications précédentes 1 à 7, **caractérisé en ce que** pour la zone du système de stockage des objets (7) et pour la zone du système de stockage de contenants de transport (8) est prévue une alimentation d'air pur commune, notamment de la sorte qu'un flux d'air traverse successivement les deux zones.

9. Dispositif de stockage selon la revendication 8, **caractérisé en ce qu'**au moins une partie du flux d'air pur comporte au moins une composante d'écoulement par l'extérieur dans la direction de l'intérieur du système de stockage des objets (7) conçu en forme de carrousel.

10. Dispositif de stockage selon au moins l'une quelconque des revendications précédentes, **caractérisé en ce que** dans le boîtier (2) est prévu un système d'ouverture des contenants de transport et de préférence sur l'un des côtés de celui-ci, un système de manipulation des contenants de transport (5) et sur l'autre côté de celui-ci, un système de manipulation des objets (6), destiné à manipuler les objets qui doivent être stockés.

11. Dispositif de stockage selon au moins l'une quelconque des revendications précédentes, **caractérisé par** un système de manipulation des objets (6) et un système de manipulation des contenants de transport (5), qui sont munis chacun d'un entraînement, destiné à réaliser des déplacements dans une direction au moins sensiblement verticale, l'entraînement du système de manipulation des objets (6) étant toujours placé en-dessous d'un grappin du système de manipulation des objets (6) et l'entraînement du système de manipulation des contenants de transport (5) étant toujours placé au-dessus d'un grappin du système de manipulation des contenants de transport (5).

12. Dispositif de stockage selon au moins l'une quelconque des revendications précédentes, **caractérisé en ce que** le système de stockage des objets (7) comporte plusieurs modules de stockage (47) qui sont munis chacun de plusieurs éléments de stockage, les éléments de stockage (48) prévus pour recevoir chacun un objet, notamment un support de substrat (28) étant empilables et déplaçables les uns par rapport aux autres, notamment séparables les uns des autres.

13. Dispositif de stockage selon la revendication 12, **caractérisé en ce que** des modules de stockage (47) sont susceptibles d'être envahis d'azote, notamment par alimentation d'azote dans un canal vertical latéral vertical des modules de stockage (47), à partir duquel de l'azote s'écoule au moins approximativement à l'horizontale à travers les éléments de stockage (48) individuels.

14. Dispositif de stockage selon l'une quelconque des revendications 1 à 13, pourvu d'un module de stockage des objets, destiné à être placé dans le dispositif de stockage, **caractérisé en ce que** le module de stockage (47) est muni de plusieurs éléments de stockage (48) empilés dans la direction verticale et déplaçables les uns par rapport aux autres, notamment séparables les uns des autres, **en ce que** chaque élément de stockage (48) comporte une zone de logement, destinée à ne recevoir qu'un seul objet, ainsi qu'une zone de stockage, destinée à être placée contre un élément de stockage (48) suivant dans la direction de stockage.

15. Dispositif de stockage selon la revendication 14, **caractérisé en ce que** notamment du fait d'un élément de fond inférieur (56) placé sur la face inférieure du module de stockage (47) et d'un élément de recouvrement (57) placé sur la face supérieure à l'intérieur du module de stockage (47) est conçu un espace clos sur l'environnement.
